(19) Europäisches Patentamt
European Patent Office
Office européen des brevets

(11) **EP 3 004 430 B1**

(12) **FASCICULE DE BREVET EUROPEEN**

(45) Date de publication et mention
de la délivrance du brevet:
**26.09.2018 Bulletin 2018/39**

(51) Int Cl.:
***C30B 11/14*** *(2006.01)*  ***C30B 29/06*** *(2006.01)*
***B28D 5/00*** *(2006.01)*

(21) Numéro de dépôt: **14729450.8**

(22) Date de dépôt: **26.05.2014**

(86) Numéro de dépôt international:
**PCT/IB2014/061722**

(87) Numéro de publication internationale:
**WO 2014/191899 (04.12.2014 Gazette 2014/49)**

(54) **PROCEDE DE FABRICATION D'UN LINGOT DE SILICIUM PAR REPRISE SUR GERMES EN FOUR DE SOLIDIFICATION DIRIGEE**

VERFAHREN ZUR HERSTELLUNG EINES SILICIUMZYLINDERS DURCH WACHSTUM AUF KEIMEN IN EINEM GERICHTETEN ERSTARRUNGSOFEN

METHOD FOR MANUFACTURING A SILICON CYLINDER BY GROWTH ON SEEDS IN A DIRECTED SOLIDIFICATION FURNACE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.05.2013 FR 1354759**

(43) Date de publication de la demande:
**13.04.2016 Bulletin 2016/15**

(73) Titulaire: **Commissariat à l'Energie Atomique et aux Energies Alternatives 75015 Paris (FR)**

(72) Inventeurs:
• **PIHAN, Etienne**
**F-73290 La Motte Servolex (FR)**
• **AMARAL DE OLIVEIRA, Vanessa**
**88040-440 Carvoeira, Florianópolis/SC (BR)**
• **CAMEL, Denis**
**F-73000 Chambéry (FR)**
• **CHAVRIER, Denis**
**F-73170 Yenne (FR)**
• **FORTIN, Gautier**
**F-73190 Saint-Baldoph (FR)**
• **JOUINI, Anis**
**F-73000 Chambéry (FR)**
• **MARIE, Benoit**
**F-73100 Aix-les-Bains (FR)**
• **PLASSAT, Nelly**
**F-73160 Vimines (FR)**

(74) Mandataire: **Nony
11 rue Saint-Georges
75009 Paris (FR)**

(56) Documents cités:
WO-A2-2009/014957    CN-A- 102 268 724
DE-A1-102011 075 093    DE-A1-102011 086 669
DE-A1-102012 102 597

• **K. KUTSUKAKE, N. USAMI, Y. OHNO, Y. TOKUMOTO, I. YONENAGA: "Control of grain boundary propagation in mono-like Si: utilization of functional grain bondaries", APPLIED PHYSICS EXPRESS, vol. 6, 025505, 31 janvier 2013 (2013-01-31), pages 025505-1-025505-3, XP002716236, DOI: 10.7567/APEX.6.025505**
• **KUTSUKAKE KENTARO ET AL: "Influence of structural imperfection of[Sigma]5 grain boundaries in bulk multicrystalline Si on their electrical activities", JOURNAL OF APPLIED PHYSICS, AMERICAN INSTITUTE OF PHYSICS. NEW YORK, US, vol. 101, no. 6, 19 mars 2007 (2007-03-19) , pages 63509-063509, XP012098025, ISSN: 0021-8979, DOI: 10.1063/1.2710348**

- **TAKAHASHI I ET AL: "Generation mechanism of dislocations during directional solidification of multicrystalline silicon using artificially designed seed", JOURNAL OF CRYSTAL GROWTH, ELSEVIER, AMSTERDAM, NL, vol. 312, no. 7, 15 mars 2010 (2010-03-15) , pages 897-901, XP026929260, ISSN: 0022-0248, DOI: 10.1016/J.JCRYSGRO.2010.01.011 [extrait le 2010-01-18]**

**Description**

La présente invention se rapporte à un nouveau procédé de fabrication d'un lingot de silicium, présentant une proportion de zone monocristalline accrue, avantageusement appauvrie en défauts cristallins, notamment en macles.

Une telle zone monocristalline peut être avantageusement dédiée à donner, par découpe, des plaquettes de silicium monocristallin d'excellente qualité cristalline. De telles plaquettes sont particulièrement avantageuses dans le cadre de l'élaboration de cellules et modules photovoltaïques.

Actuellement, les cellules photovoltaïques sont majoritairement fabriquées à partir de silicium mono ou multi-cristallin. La filière de production de silicium cristallin la plus courante met en jeu la solidification de lingots à partir d'un bain de silicium liquide. Ces lingots sont ensuite découpés en plaquettes qui peuvent être transformées en cellules photovoltaïques.

Les lingots de silicium multicristallin sont classiquement réalisés par fusion d'une charge de silicium, suivie d'une solidification dirigée. Cette technique permet avantageusement de cristalliser de grands volumes de silicium ; et la taille des lingots usinés peut être ajustée en variant la dimension des creusets.

Malheureusement, ce procédé très productif présente un inconvénient majeur au regard de la structure cristalline des lingots de silicium ainsi réalisés. De fait, cette technique conduit à des lingots présentant une structure cristalline caractérisée par un nombre très important de grains et d'orientations cristallines différentes, mais également par une densité de dislocations élevée, ces dislocations étant réparties de manière inhomogène dans le lingot. Par conséquent, ce procédé n'est pas efficace pour obtenir un lingot de silicium quasi-monocristallin, dit « mono-like », c'est-à-dire constitué très majoritairement (notamment à plus de 90 %) de matériau monocristallin.

Depuis quelques années, des techniques ont été développées pour élaborer des lingots de silicium mono-like par solidification dirigée dans un four avec des structures cristallines améliorées, notamment *via* un meilleur contrôle de la germination, comme décrit dans le document Fujiwara et al., Growth of structure-controlled polycrystalline silicion ingots for solar cells by casting, Acta Materialia, 54 (2006), 3191-3197, ou encore *via* l'utilisation de germes monocristallins pavant le fond du creuset (technique dite de reprise sur germes), comme proposé dans les documents WO 2007/084934, US 2010/0192838, US 2010/0193989, US 2010/0193664, WO 2009/014963, US 2010/0197070 et US 2013/0095028.

WO 2009/014957 décrit un procédé de solidification dirigée d'un lingot de silicium selon le préambule de la revendication 1 du présent document, en particulier à partir d'un pavage de germes comportant des germes centraux d'orientation (100) entourés de germes périphériques d'orientation (111).

L'article KUTSUKAKE K ET AL: "Control of grain boundary propagation in mono-like Si: utilization of functional grain boundaries", Applied Physics Express 6 (2013) 025505 enseigne de mettre en oeuvre des interfaces de joints de grain à faible énergie avec $\Sigma$=5 pour séparer les germes périphériques des germes centraux et, de ce fait, limiter la croissance d'un domaine multi-cristallin à partir de la périphérie d'un creuset.

Malheureusement, la fabrication d'un lingot de silicium, par reprise sur germes en four de solidification dirigée, pose un problème de diminution de la proportion de cristaux issus des germes avec la hauteur du lingot. Cette diminution est préjudiciable à la qualité du lingot obtenu, étant donné que les cristaux issus des germinations en périphérie des zones de germes présentent une quantité de défauts cristallins inacceptable pour une utilisation en tant que cellules photovoltaïques. De fait, une zone multicristalline, se développant à partir des bords du creuset sur toute la hauteur du lingot, est susceptible de venir dégrader la qualité du lingot formé à partir des germes en fond de creuset.

Pour améliorer la qualité des lingots élaborés par reprise sur germe, il importe, par conséquent, d'augmenter la proportion des cristaux issus des germes.

Plusieurs facteurs peuvent être à l'origine de la diminution de la proportion des cristaux issus des germes avec la hauteur de lingot : ils peuvent être notamment liés à la thermique du four, ou à la croissance de défauts cristallins.

La thermique d'un four de solidification dirigée est caractérisée par la forme de l'avancée du front de fusion et de solidification.

Par « front de fusion et de solidification » du four, appelé plus simplement dans la suite du texte, « front de solidification » du four, on entend désigner l'interface silicium solide/ silicium liquide (ou fondu) au cours de la solidification dirigée du silicium dans le creuset.

Deux grands types de thermiques de four existent : les fours à front de solidification convexe et les fours à front de solidification concave.

Un front de solidification concave, convexe respectivement, est tel que l'interface solide-liquide est située verticalement à une altitude plus élevée, moins élevée respectivement, au niveau des parois du creuset qu'au centre du creuset, lors de la solidification dirigée.

Dans le cas d'une thermique convexe, voire très convexe, les temps de cycles sont longs, car la solidification des coins en fin de cycle est lente (typiquement de 8 à 9 heures).

Un front de solidification concave, voire proche de la planéité, permet de s'affranchir des principaux inconvénients liés à une thermique convexe. Les thermiques avec un front de solidification, spatialement ou temporellement, concave ou proche de la planéité sont les plus adaptés pour la production de lingots par reprise sur germes. Un front de solidification proche de la planéité est particulièrement préféré puisqu'il permet d'utiliser des germes en fond de creuset d'épaisseur minimale.

Malheureusement, la portion monocristalline au niveau du silicium solidifié au bord des parois du creuset diminue drastiquement avec la hauteur du lingot. Ce phénomène résulte, d'une part, de la propagation de grains parasites venant de la germination en paroi latérale du creuset ou sur des zones périphériques ne présentant pas de germes, et d'autre part, de la propagation de macles vers le coeur du lingot.

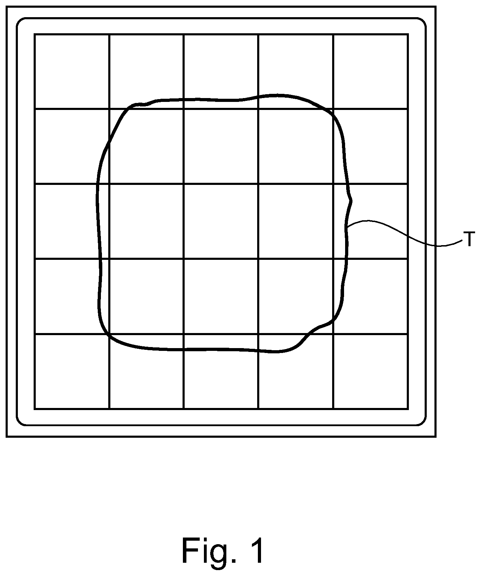

Ainsi, les macles et germinations réduisent la proportion monocristalline du lingot exploitable pour produire des briques. La figure 1 illustre cette conséquence pour la découpe d'un lingot dit « G5 » en 25 briques. Si les germes déposés en fond de creuset couvrent cette surface de futures briques, la surface effectivement monocristalline en haut de lingot est réduite à la zone interne du tracé T, du fait des effets de bord se développant sur toute la hauteur de lingot lors de sa solidification.

La présente invention vise précisément à palier les inconvénients précités et à optimiser la proportion monocristalline exploitable d'un lingot de silicium obtenu par reprise sur germes en four à front de solidification, spatialement ou temporellement, concave.

La présente invention concerne ainsi, selon un premier de ses aspects, un procédé de fabrication d'un lingot de silicium par reprise sur germes en four de solidification dirigée, comprenant au moins les étapes consistant en :

(i) disposer d'un creuset (1) d'axe (Z) longitudinal, dont le fond comporte un pavage de germes (2) de silicium monocristallin de forme prisme droit ; et

(ii) procéder à la solidification dirigée de silicium par reprise sur germes, selon une direction de croissance colinéaire à l'axe (Z) et avec un front de solidification, spatialement ou temporellement, concave ;

caractérisé en ce que le pavage en étape (i) est formé :

- d'un ou plusieurs germes centraux $G_c$ ; et
- d'un ou plusieurs germes périphériques $G_p$, contigu(s) au(x) germe(s) $G_c$,

un germe $G_p$ présentant un réseau cristallin symétrique du réseau cristallin du germe $G_c$ contigu, par rapport au plan P défini par la frontière (3) entre lesdits germes $G_p$ et $G_c$ ;
le ou lesdits germes $G_p$ présentant, dans un plan vertical de coupe, une largeur ($l_p$) strictement inférieure à la largeur totale ($l_u$) du ou desdits germes centraux ; et
les germes périphériques $G_p$ étant dimensionnés de manière à ce que :

$$l_p = d - b$$

avec :

- d vérifiant : $d \geq H.\tan \theta_{max}$ avec $\theta_{max}$ la valeur maximale de l'angle $\theta$ du front de solidification du four utilisé ; et H la hauteur, mesurée selon l'axe (Z), du lingot de silicium souhaitée ; et
- b=0 pour un creuset à angles droits, et b=$R_{interne\ creuset}$, avec $R_{interne\ creuset}$ la taille du chanfrein pour un creuset à arrêtes arrondies.

Par « spatialement ou temporellement » concave, on entend signifier qu'à un instant donné de la progression du front de solidification, ou en un point donné du front de solidification, l'interface solide/liquide est de forme concave.

Dans la suite du texte, et sauf indication contraire, un germe et/ou lingot et/ou plaquette, définis par la suite, sont caractérisés pour le référentiel orthogonal d'axes (x), (y) et (z), correspondant aux trois directions principales, respectivement du germe, du lingot ou de la plaquette. L'axe (z) d'un germe et/ou d'un lingot est colinéaire à l'axe (Z) longitudinal du creuset.

L'axe (Z) longitudinal du creuset désigne la ligne joignant l'ensemble des barycentres des sections transversales dudit creuset (parois du creuset inclus). L'axe longitudinal peut être plus particulièrement un axe de symétrie pour le creuset.

On entend bien entendu par « forme prisme droit », une forme approximativement de type prisme de droit. En particulier, les germes présentent des parois latérales verticales ou sensiblement verticales (déviation de $\pm$ 5°). Par ailleurs, les germes du pavage en fond de creuset présentent des surfaces approximativement planes, aux irrégularités de surface près.

On désignera dans la suite du texte, comme étant la « base du germe », la surface globalement plane du germe en regard du fond du creuset.

Comme détaillé par la suite, la base des germes peut être de forme variée, notamment de forme carrée ou rectangulaire ou encore parallélogramme. De préférence, elle est de forme carré ou rectangulaire, les germes étant alors approximativement de forme pavé droit.

La largeur « $l_p$ » d'un germe périphérique correspond, dans un plan vertical de coupe, à la distance entre deux parois successives dudit germe périphérique.

De manière avantageuse, les inventeurs ont ainsi découvert qu'il est possible de maintenir la croissance de la zone monocristalline issue des germes $G_c$ sur toute la hauteur du lingot formé, *via* le positionnement de germes périphériques $G_p$ dimensionnés de manière appropriée comme décrit précédemment.

En effet, avec un pavage de germes conforme à l'invention, comme développé plus précisément dans la suite du texte, la zone multicristalline germant à partir des parois du creuset n'interfère pas avec le joint de grains se propageant à partir de l'interface entre germes $G_p$ et $G_c$. Qui plus est, les macles, crées à partir de la zone multicristalline, sont stoppées au niveau de ce joint de grains, et ne peuvent donc se propager librement vers le coeur monocristallin du lingot.

La zone monocristalline centrale du lingot, encore appelée dans la suite du texte « lingot central », se développant à partir des germes centraux, est ainsi d'excellente qualité cristalline.

Il est également décrit dans la présente demande un lingot de silicium, obtenu selon le procédé défini précédemment, présentant un coeur monocristallin séparé par des joints de grains, de préférence sensiblement verticaux, d'une zone multicristalline périphérique.

Elle vise encore, selon un autre de ses aspects, un procédé de fabrication d'un lingot de silicium monocristallin, comprenant au moins une étape (iii), de découpe du lingot tel que défini précédemment, le long des plans P définis par l'interface entre deux germes $G_p$ et $G_c$ contigus, de manière à éliminer les zones multicristallines formées à l'aplomb des germes $G_p$.

D'autres caractéristiques, avantages et modes d'application du procédé et du lingot de silicium obtenu selon l'invention, ressortiront mieux à la lecture de la description détaillée qui va suivre, de l'exemple de réalisation de l'invention et à l'examen des dessins annexés, sur lesquels :

- la figure 1 représente, de manière schématique et en vue de dessus, la surface monocristalline, délimitée extérieurement par le tracé T, en haut de lingot, pour une solidification classique par reprises sur germes d'un lingot G5 ;
- la figure 2 représente, de manière schématique et partielle, un pavage en fond de creuset conforme à l'invention à l'aide des germes $G_c$ et $G_p$, en coupe transversale (figure 2a) et en vue de dessus (figure 2b) ;
- la figure 3 représente, de manière schématique, la détermination du front de solidification à l'aide d'une méthode cristallographique (figure 3a) ou à l'aide d'une cartographie de résistivité (figure 3b) ;
- la figure 4 représente, de manière schématique et partielle, en coupe transversale, le positionnement d'un germe périphérique $G_p$ dans le cas d'un creuset à angles droits (figure 4a) et d'un creuset à chanfreins (figure 4b) ;
- la figure 5 représente, de manière schématique et partielle, en coupe transversale, l'évolution de la zone multicristalline 4 et des macles 5 dans un lingot formé selon l'invention, à partir de germes $G_c$ et $G_p$ présentant des réseaux cristallins symétriques ;
- la figure 6 représente schématiquement, en vue 3D, la formation des germes contigus par rotation d'un angle de 180° (ou retournement) autour de l'axe (y) ou de l'axe (x) ;
- la figure 7 représente, en vue 3D, le briquetage d'un lingot central de silicium 7 monocristallin selon les plans $P_c$ ($P_{c1}$, $P_{c2}$, $P_{c3}$, ...).
- la figure 8 représente la détermination, à l'aide d'une étude cristallographique, de l'angle $\theta_{max}$ lors de l'essai de solidification dirigée effectué en exemple.
- la figure 9 est une image photographique d'une tranche verticale de lingot de section 388 x 180 mm. Les conditions d'obtention sont celles détaillées dans l'exemple ; et la structure des germes est révélée par l'opération de découpe et de nettoyage se traduisant par un contraste optique variant pour chaque orientation cristalline ;
- la figure 10 représente, de manière schématique et partielle, en coupe transversale, l'évolution de la zone multicristalline 4 et des macles 5 dans un lingot formé par reprise sur germes, à partir de germes $G_c$ et $G_p$ ne présentant pas des réseaux cristallins symétriques.

Il convient de noter que, pour des raisons de clarté, les différents éléments sur les figures sont représentés en échelle libre, les dimensions réelles des différentes parties n'étant pas respectées.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, l'expression « comportant/comprenant un(e) » doit être comprise comme « comportant/comprenant au moins un(e) ».

### Pavage en fond de creuset (étape (i))

Comme précisé précédemment, le procédé de l'invention met en oeuvre un pavage, en fond de creuset, par des germes 2 de silicium monocristallin de forme prisme droit.

Le pavage de germes 2 peut être formé au fond d'un creuset classique. On peut encore envisager des creusets dont le fond lui-même est formé du pavage de germes.

Selon un mode de réalisation particulièrement préféré, les germes 2 sont de forme pavé droit, de base carrée ou rectangulaire.

Selon une caractéristique essentielle de l'invention, le pavage de germes 2 est formé :

- d'un ou plusieurs germes centraux, notés $G_c$ ; et
- d'un ou plusieurs germes périphériques, notés $G_p$, contigu(s) au(x) germe(s) $G_c$.

*Dimensionnement des germes périphériques*

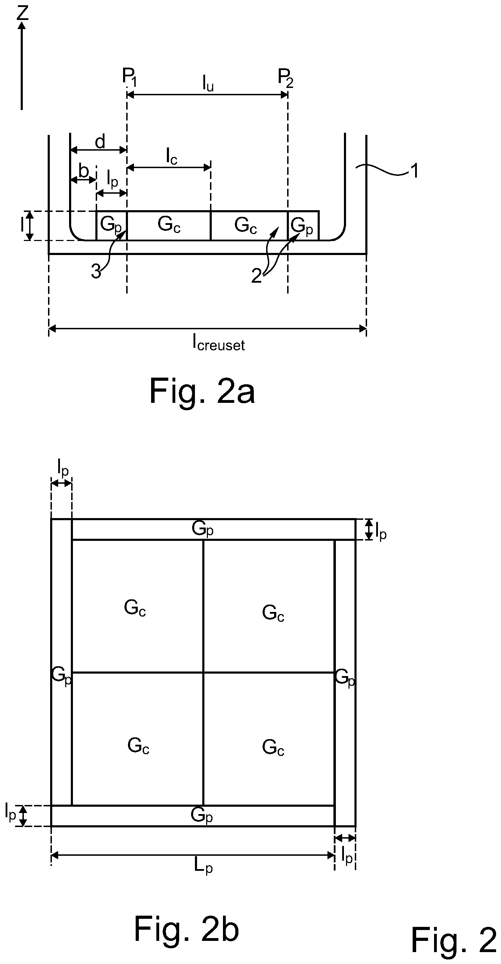

Comme représenté en figure 2a, un germe $G_p$ selon l'invention est dimensionné de manière à ce que la largeur (noté $l_p$) du germe périphérique dans un plan vertical de coupe, vérifie :

$$l_p = d - b \; ;$$

avec :

- d étant tel que $d \geq H. \tan \theta_{max}$, avec $\theta_{max}$ la valeur maximale de l'angle $\theta$ du front de solidification du four utilisé et H la hauteur souhaitée pour le lingot ; et
- b=0 pour un creuset à angles droits, et b=$R_{interne\ creuset}$, avec $R_{interne\ creuset}$ la taille du chanfrein pour un creuset à arrêtes arrondies.

d représente plus particulièrement l'espacement, dans un plan vertical de coupe, entre l'interface 3 entre un germe périphérique $G_p$ et un germe central $G_c$ contigus, et la paroi latérale du creuset la plus proche.

Pour définir la largeur $l_p$ d'un germe périphérique $G_p$, il est nécessaire de déterminer dans un premier temps la distance d. Celle-ci est choisie telle que $d \geq H. \tan \theta_{max}$.

De manière classique, la hauteur H, mesurée suivant l'axe Z de croissance, du lingot peut être choisie supérieure ou égale à 100 mm, en particulier comprise entre 180 et 800 mm.

La valeur $\theta_{max}$ peut être par exemple déterminée à l'issue d'un essai de solidification dirigée, effectué dans le même creuset 1, d'un lingot de silicium de hauteur $H_{essai}$ similaire à la hauteur H du lingot souhaité, obtenu par reprise sur germes.

L'essai de solidification dirigée en vue de la détermination de l'angle $\theta_{max}$ peut être par exemple réalisé en pavant le fond du creuset de germes Cz, autrement dit de germes issus d'un lingot de silicium élaboré selon une technique de tirage de Czochralski (encore appelé lingot « *Cz* »), ou en pavant le fond du creuset de germes « Fz », autrement dit de germes issus d'un lingot élaboré selon un procédé de zone de flottation (ou « float-zone » en langue anglaise), encore appelé procédé « Fz ».

Il appartient à l'homme du métier de déterminer, par des méthodes conventionnelles, la valeur $\theta_{max}$ à partir de l'essai de solidification réalisé.

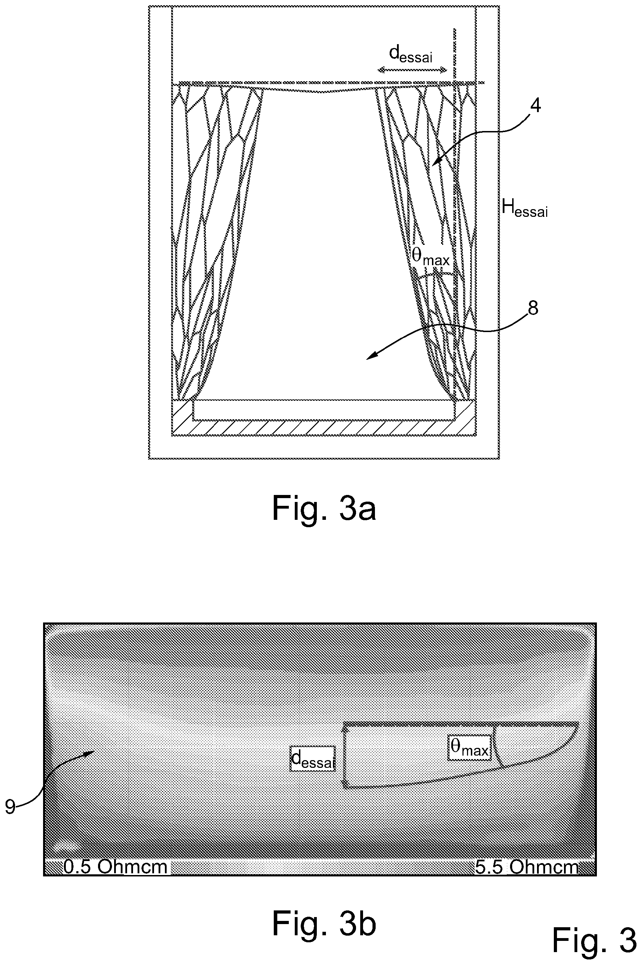

Comme illustré sur la figure 3a, la valeur $\theta_{max}$ peut être déterminée à l'aide d'une méthode cristallographique, en observant le changement de structure entre la zone monocristalline 8 et la zone multicristalline 4 en haut du lingot formé de hauteur $H_{essai}$, qui renseigne sur la déviation de la zone multicristalline de bas en haut du lingot.

La valeur $\theta_{max}$ peut être ainsi calculée, à l'issue de l'essai de solidification dirigée, par la formule suivante : $\tan \theta_{max} = d_{essai}/H_{essai}$, avec $d_{essai}$ étant la distance la plus éloignée du bord de creuset où se situe la zone multicristalline pour le lingot de hauteur $H_{essai}$ obtenu lors de l'essai, comme représenté schématique en figure 3a.

D'autres méthodes de détermination de l'angle $\theta_{max}$ peuvent être utilisées. A titre d'exemple, il peut être déterminé à l'aide d'une cartographie de résistivité lors d'un essai de solidification dirigée d'un lingot de silicium avec un dopage en bore.

De fait, le bore, présentant un coefficient de ségrégation k=0,8 ségrégue de manière homogène dans le volume du lingot au cours de la solidification. Il en résulte une variation locale de la résistivité du lingot, qui suit l'évolution de l'interface solide-liquide pendant la cristallisation du silicium. Une ligne d'isorésistivité 9 observée sur la cartographie de résistivité correspond ainsi au front de solidification à un instant donné. L'angle du front de solidification $\theta_{max}$ peut

donc être directement mesuré sur les courbes d'isorésistivité définies sur la cartographie de résistivité, comme représenté schématiquement en figure 3b.

Selon un mode de réalisation préféré, d est choisi égal à H. tan $\theta_{max}$, de manière à optimiser la largeur totale ($l_u$) du lingot central obtenu.

Le ou lesdits germes $G_p$ peuvent présenter dans un plan vertical de coupe, une largeur $l_p$ inférieure ou égale à 157 mm, en particulier comprise entre 5 et 40 mm.

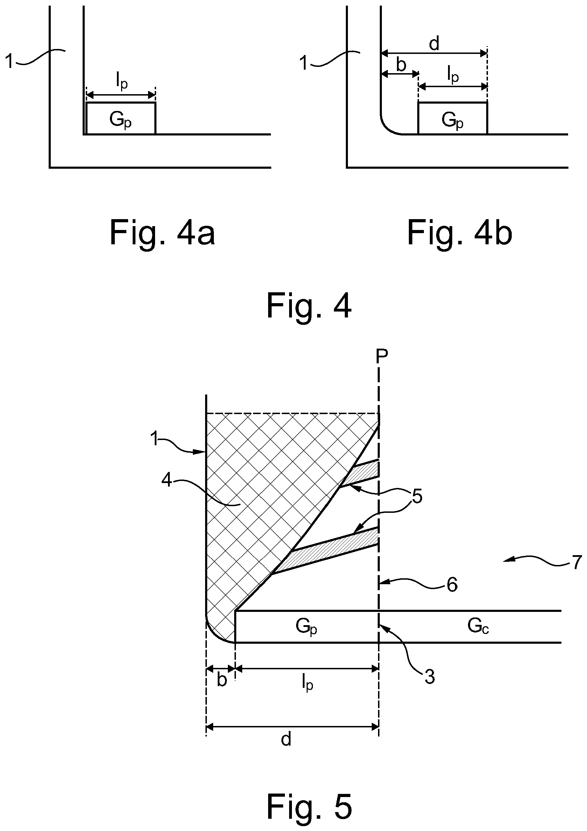

Dans une première variante de réalisation, le creuset utilisé peut être un creuset à angles droits (autrement dit, b=0). Comme représenté en figure 4a, le germe $G_p$ peut être, dans ce cas, accolé à la paroi latérale 1 du creuset.

Dans le cadre de cette variante, un germe $G_p$ est de largeur $l_p$ = d, d étant tel que défini précédemment, de préférence d = H. tan $\theta_{max}$.

Dans une seconde variante de réalisation, le creuset utilisé peut être un creuset à arrêtes arrondies, encore appelé creuset avec chanfreins. Comme représenté en figure 4b, le germe $G_p$ peut être, dans ce cas, espacé de la paroi latérale 1 du creuset d'une distance b égale à la taille du chanfrein du creuset $R_{interne\ creuset}$ (typiquement comprise entre 2 et 40 mm).

Dans le cadre de cette variante, un germe $G_p$ est de largeur $l_p$ = d-b, avec d étant tel que défini précédemment, de préférence d = H. tan $\theta_{max}$.

Comme représenté en figure 5, le germe périphérique $G_p$ ainsi dimensionné permet avantageusement que la zone multicristalline 4, se propageant à partir de la paroi du creuset, n'ait aucune interférence avec le joint de grains 6 crée à partir de l'interface 3 entre $G_p$ et $G_c$.

Ainsi, grâce à la mise en oeuvre de germes périphériques selon l'invention, les germinations sur les parois du creuset n'induisent pas de diminution de la proportion de zone monocristalline issue des germes $G_c$ sur la hauteur du lingot.

Les dimensions autres que la largeur $l_p$ d'un germe périphérique peuvent être choisies indépendamment de la thermique du four.

Selon un mode de réalisation particulier, un germe $G_p$ peut présenter une épaisseur e suivant l'axe Z, supérieure ou égale à 5 mm. A titre d'exemple, elle peut être d'environ 20 mm.

De préférence, les germes périphériques présentent une épaisseur proche, voire identique, à celle du ou des germes centraux.

Selon un mode de réalisation particulièrement préféré, les germes $G_p$ sont de forme pavé droit, de largeur $l_p$ et de longueur $L_p$ choisie de manière à ce qu'un seul type de germe $G_p$ soit nécessaire pour le pavage le long du côté du creuset, comme représenté par exemple en figure 2b.

Le pavage central peut être formé d'un ou plusieurs germes centraux $G_c$.

On désignera par « $l_u$ » (pour « largeur utile ») la largeur totale, dans un plan vertical de coupe, des germes centraux. $l_u$ vérifie plus particulièrement $l_u$ = $l_{creuset}$ - 2d, avec $l_{creuset}$ la largeur du creuset, dans le plan de coupe, et d tel que défini précédemment.

Le ou lesdits germes $G_c$ peuvent ainsi présenter, dans un plan vertical de coupe, une largeur $l_c$ inférieure ou égale à $l_u$, en particulier comprise entre 110 mm et $l_u$/n avec n le nombre de germes centraux accolés, n pouvant notamment être compris entre 1 et 10.

Les germes centraux sont de préférence de forme pavé droit, de base carrée ou rectangulaire. De tels germes permettent avantageusement un pavage central en fond du creuset sous la forme d'un quadrillage régulier. Comme détaillé dans la suite du texte, un tel pavage s'avère avantageux, dans le cadre de la formation de joints de grains symétriques dans le lingot central, notamment pour le briquetage du lingot formé à l'issue du procédé de l'invention.

Selon une première variante de réalisation, le pavage central est réalisé à l'aide de germes $G_c$ de forme pavé droit à base carrée, comme représenté en figure 2b, par exemple de côté ($l_c$) d'un carré compris entre 110 mm et $l_u$/n, avec $l_u$ et n définis précédemment, en particulier de côté $l_c$ d'un carré supérieur ou égal à 95 mm.

A titre d'exemple, la figure 2b représente un pavage central sous forme carrée, dit « G2 », formé de 4 germes centraux de forme pavé droit à base carrée.

Selon une seconde variante de réalisation, le pavage central est réalisé à l'aide de germes $G_c$ de forme pavé droit à base rectangulaire, par exemple de largeur d'un rectangle comprise entre 110 mm et $l_u$/n, en particulier de largeur supérieure ou égale à 95 mm et de longueur supérieure ou égale à deux fois la largeur.

Les germes $G_c$ peuvent présenter une épaisseur suivant l'axe Z, supérieure ou égale à 5 mm. De préférence, l'ensemble des germes $G_c$ formant le pavage en fond de creuset présente la même épaisseur (e) suivant l'axe Z.

Comme évoqué précédemment, dans un mode de réalisation particulièrement préféré, les germes centraux et périphériques présentent des épaisseurs similaires, voire identiques.

Les germes $G_c$ et $G_p$ de silicium mono-cristallin mis en oeuvre pour le pavage selon l'invention, peuvent être issus d'un lingot de silicium élaboré selon une technique de tirage Czochraslski (encore appelé lingot « Cz »), technique dans laquelle un cristal de silicium est mis en contact avec un bain de silicium en fusion, afin de faire croître un lingot monocristallin.

Cette méthode fournit généralement des lingots Cz de forme cylindrique. Ils peuvent être usinés, de manière conventionnelle, et découpés en tranches perpendiculaires ou parallèlement à l'axe du cylindre, pour obtenir des germes de forme pavé droit.

Selon une autre variante de réalisation, les germes $G_c$ et $G_p$ de silicium mono-cristallin proviennent du recyclage d'un lingot élaboré lors d'une précédente solidification dirigée selon le procédé de l'invention, par exemple par prélèvement d'une tranche horizontale du lingot de silicium formé.

Comme indiqué précédemment, un germe $G_c$ présente un réseau cristallin symétrique du réseau cristallin du germe $G_p$ qui lui est contigu, par rapport au plan P défini par le joint de germe 3 entre lesdits germes $G_p$ et $G_c$.

Une telle symétrie des réseaux cristallins des germes $G_c$ et $G_p$ permet, lors de l'étape (ii) de solidification dirigée de silicium, la propagation de joints de grain symétriques 6 à partir des joints de germes 3, comme représenté schématiquement en figure 5.

Par « joint de grains symétrique », on entend désigner un joint de grains plan, présent dans le lingot de silicium formé à l'issue de la solidification dirigée de silicium, et définissant un plan de symétrie cristalline P pour les réseaux cristallins situés de part et d'autre de ce plan.

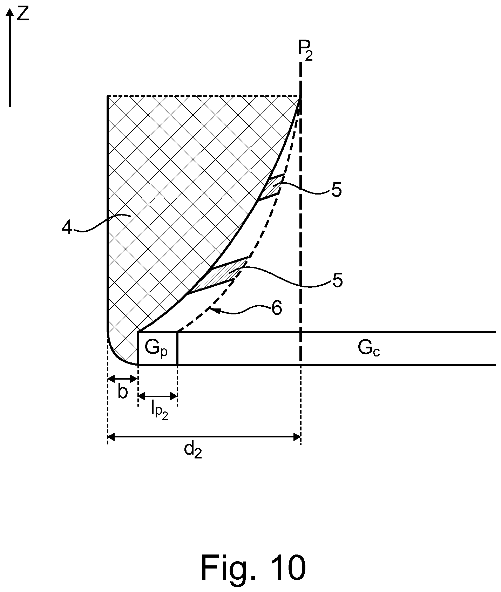

Comme représenté schématiquement en figure 5 et illustré dans l'exemple 1 (figure 10), le joint de grains 6 permet avantageusement de bloquer la propagation des macles 5 créées à partir de la zone multicristalline en bordure du creuset.

Selon une variante de réalisation particulière, le pavage central peut être également formé de germes $G_c$ présentant des réseaux cristallins symétriques les uns des autres ; autrement dit chaque germe $G_c$ présente un réseau cristallin symétrique du réseau cristallin du germe $G_c$ qui lui est contigu, par rapport au plan défini par la frontière entre les deux germes $G_c$ contigus.

Ce mode de réalisation s'avère particulièrement avantageux pour maîtriser la propagation des joints de grains dans le lingot central monocristallin formé.

Dans un premier mode de réalisation, un germe périphérique $G_p$ peut posséder des orientations suivant les directions (x), (y) et (z), identiques, aux incertitudes de découpe et de positionnement près au fond du creuset, à celles du germe central $G_c$ qui lui est contigu.

A titre d'exemple, les germes $G_c$ et $G_p$ peuvent être prélevés dans un même lingot Cz, par exemple par découpe du lingot Cz perpendiculairement à la direction de croissance du cristal mis en oeuvre dans le procédé de Czochralski.

Dans un second mode de réalisation, le germe périphérique $G_p$ et le germe central $G_c$ peuvent présenter des orientations cristallographiques distinctes. De préférence, la désorientation, telle que définie ci-après, entre les germes $G_p$ et $G_c$ s'effectue autour d'un axe de désorientation parallèle à l'axe (z). Autrement dit, les germes $G_c$ et $G_p$ présentent des orientations cristallines distinctes suivant les directions (x) et (y).

D'une manière générale, la différence d'orientation entre les réseaux cristallins de deux germes 2 est appelée « désorientation ». Cette désorientation se traduit par une opération de rotation autour d'un axe de désorientation <u v w> et d'un angle de désorientation $2\varphi$. Par la suite, on nommera «désorientation totale », l'angle de désorientation $2\varphi$ le plus petit parmi toutes les opérations de rotation précitées ; et on nommera « axe de désorientation », l'axe associé à cet angle.

De préférence, la désorientation totale $2\varphi$ entre les réseaux cristallins symétriques de deux germes (2) contigus, notés pour les différencier « germe A » et « germe B » (qu'il s'agisse de deux germes $G_p$ et $G_c$ contigus ou, dans la variante précitée, de deux germes $G_c$ contigus) est supérieure ou égale à 4°, en particulier supérieure ou égale à 5°, et plus particulièrement comprise entre 6° et 45°.

Selon un mode de réalisation particulier, les réseaux cristallins de deux germes symétriques 2 contigus présentent tous deux une direction colinéaire à l'axe (Z), de préférence une direction <100> ou proche de <100> colinéaire à l'axe (Z), chacun des germes étant avantageusement désorienté selon un même angle θ par rapport à cette direction selon (x) et/ou (y).

La désorientation θ d'un germe peut être déterminée par des méthodes de mesure connues de l'homme du métier, par exemple par mesure des angles avec la méthode de Laue, par diffraction de rayon X ou encore par diffraction des électrons rétrodiffusés (ESBD pour « Electron BackScattered Diffraction » en langue anglaise).

Cependant, de manière avantageuse, il est possible de s'affranchir de la mesure des angles de désorientation θ de chacun des germes mis en oeuvre, en réalisant le pavage de germes contigus de réseaux cristallins symétriques l'un par l'autre, à partir d'un seul type de germes.

Ainsi, selon un mode de réalisation particulier, le pavage en fond de creuset par des germes 2 contigus, notés germe A et germe B, de réseaux cristallins symétriques l'un de l'autre, peut être réalisé à partir de germes de silicium identiques, le germe B étant obtenu à partir d'un germe A ayant subi une rotation d'un angle de 180° autour de l'un des vecteurs perpendiculaires aux faces latérales du germe, c'est-à-dire dans le cadre d'un pavage sous forme d'un quadrillage, autour de l'axe (x) ou (y).

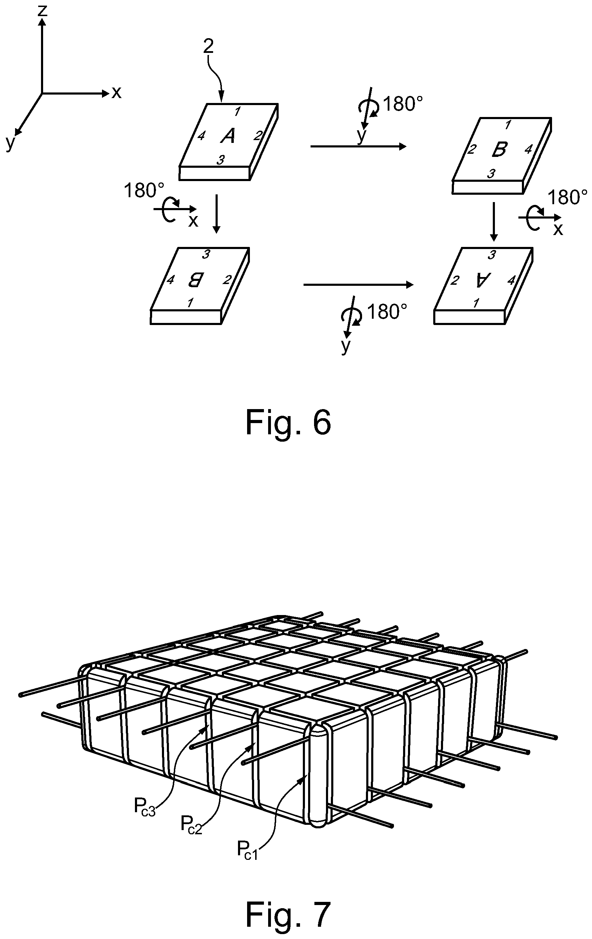

A titre d'exemple, la figure 6 représente l'obtention des germes A et B de type pavé droit, le germe B étant obtenu par rotation d'un angle de 180° autour de l'axe x et/ou de l'axe (y).

Selon un mode de réalisation préféré, dans le cas de la mise en oeuvre de germes $G_c$ de réseaux cristallins symétriques l'un par rapport à l'autre, la désorientation entre les réseaux cristallins de deux germes $G_c$ contigus s'effectue autour d'un axe <001>. De préférence, l'axe <001> est confondu avec l'axe (Z) du creuset et/ou avec l'axe (z) du germe.

Un tel mode de réalisation s'avère particulièrement avantageux, au regard des plaquettes qui seront formées par découpe du lingot central monocristallin obtenu à partir d'un tel pavage central de germes.

De fait, les surfaces des plaquettes issues de la découpe des briques perpendiculairement à la surface du lingot central, suivant les plans de joints de grains verticaux, sont, aux irrégularités de découpe près sensiblement parallèles aux plans (001). Etant d'orientation (001), les surfaces des plaquettes ainsi formés présentent la caractéristique d'être efficacement texturisées par une texturation basique (à base de KOH ou NaOH par exemple). Il peut en résulter un gain de réflectivité d'environ 5 à 12 % relatif en face, comparativement à des texturations basiques sur d'autres orientations ou à des texturations acides sur une orientation quelconque.

Selon un mode de réalisation particulier, le creuset peut être avantageusement dimensionné en fonction de la largeur $l_p$ des germes périphériques $G_p$, préalablement déterminée comme décrit précédemment, et de la largeur $l_u$ du lingot central souhaitée.

Autrement dit, la largeur du creuset, $l_{creuset}$, est choisie telle que $l_{creuset}=l_u+2l_p+2b$, avec b tel que défini précédemment.

## Solidification dirigée par reprise sur germes (étape (ii))

Dans une seconde étape du procédé de l'invention, on procède à la solidification dirigée de silicium dans le four par reprise sur germes selon une direction de croissance colinéaire à l'axe (Z) et avec un front de solidification, spatialement ou temporellement, concave.

L'homme du métier est à même d'ajuster les conditions opératoires pour l'élaboration du lingot de silicium par solidification dirigée.

Le four utilisé peut être un four conventionnel de solidification dirigée, comme par exemple un four de cristallisation de type HEM (provenant du nom anglais « Heat Exchange Method ») ou de type Bridgman avec un chauffage fixe par le haut et les côtés, qui permet de cristalliser la charge de silicium avec un gradient de température contrôlé.

D'une manière générale, la solidification dirigée est effectuée en faisant fondre, dans un premier temps, une charge de silicium dans le creuset préparé en étape (i). Lorsque le silicium est complètement en fusion, et que les germes commencent à fondre, le silicium en fusion est solidifié, de façon dirigée, à faible vitesse (typiquement de 5 à 30 mm/h).

La solidification dirigée peut être réalisée par déplacement du système de chauffage et/ou par refroidissement contrôlé, permettant un déplacement progressif du front de solidification (front de séparation entre la phase solide et la phase liquide) vers le haut du creuset.

Le lingot, de hauteur H, obtenu à l'issue de la solidification dirigé peut être ensuite refroidi, notamment jusqu'à température ambiante (20°C $\pm$ 5°C).

Comme représenté de manière schématique et partielle en figure 5, le lingot de silicium obtenu selon le procédé de l'invention présente un coeur monocristallin 7 séparé des zones multicristallines périphériques 4, par des joints de grains 6, se développant à partir des joints de germes 3 entre germes périphériques $G_p$ et germes centraux $G_c$.

## Formation du lingot monocristallin (étape (iii))

Le lingot central monocristallin 7 peut être isolé des zones multicristallines formées à l'aplomb des germes $G_p$, par découpe du lingot le long des plans P définis par l'interface entre deux germes $G_c$ et $G_p$ contigus.

Les positions de découpe du lingot sont aisément identifiables sur le lingot, dans la mesure où elles se situent au niveau des frontières entre germes $G_p$ et $G_c$ tapissant le fond du creuset.

La découpe le long des plans P peut être opérée par des moyens conventionnels, connus de l'homme du métier, par exemple à l'aide d'un fil de découpe.

Le lingot monocristallin 7 ainsi obtenu est d'excellente qualité cristalline.

En particulier, il peut présenter une part multicristalline inférieure à 5 % de son volume total.

## Plaquettes de silicium

Le lingot de silicium 7 monocristallin, obtenu à l'issue de l'étape (iii), peut ensuite être découpé en briques.

Des plaquettes de silicium peuvent être élaborées à partir de ces briques, selon des techniques classiques connues de l'homme du métier, notamment par découpe des briques, rectification des faces, éboutages des extrémités hautes et basses pour ajuster les dimensions de la plaquette, etc..

Dans le cadre de la variante de réalisation où les germes $G_c$ mis en oeuvre présentent des réseaux cristallins symétriques les uns des autres, le lingot central monocristallin présente avantageusement des joints de grains symétriques suivant les plans ($P_{c1}$, $P_{c2}$, $P_{c3}$...) définis par les frontières entre les germes $G_c$.

Selon une première variante de réalisation, la découpe du lingot de coeur en briques peut être opérée indépendamment de la position des plans de joints de grains $P_{c1}$, $P_{c2}$, $Pc_3$.... Les briques résultantes contiennent ainsi des joints de grains symétriques.

Selon une seconde variante de réalisation, la découpe du lingot de coeur en briques peut être opérée le long des plans $P_{c1}$, $P_{e2}$, $P_{e3}$, ..., comme représenté schématiquement en figure 7.

La découpe du lingot de silicium le long de ces plans, permet ainsi d'éliminer les joints de grains symétriques et d'obtenir avantageusement des briques dénuées de joints de grains. Les positions de découpe du lingot central le long des joints de grains symétriques sont aisément identifiables sur le lingot dans la mesure où elles se situent au niveau des frontières entre les germes $G_c$ contigus tapissant le fond du creuset.

Pour un pavage de germes $G_c$ de type quadrillage comme représenté schématiquement en figure 2b, la découpe peut par exemple être opérée à l'aide d'une machine conventionnelle de type Squarer ou scie à bande.

Il appartient à l'homme du métier d'adapter le pas du guide-fils, au regard de la dimension des germes $G_c$ de pavage mis en oeuvre et du diamètre des fils de découpe utilisés, de manière à ce que la découpe à l'aide du Squarer se fasse le long de chacun des plans $P_{c1}$, $P_{c2}$, ... et permette d'éliminer les joints de grains symétriques du lingot central.

Les plaquettes ainsi obtenues peuvent être avantageusement utilisées pour l'élaboration de cellules photovoltaïques, par exemple pour les filières homojonction ou hétérojonction.

D'autres variantes de réalisation du pavage en fond de creuset par des germes centraux et périphériques peuvent être envisagées..

Il est décrit un pavage avec des germes $G_c$ et $G_p$ ne présentant pas de réseaux cristallins symétriques l'un par rapport à l'autre.

Il est décrit que le pavage en étape (i) en fond de creuset peut être formé :

- d'un ou plusieurs germes centraux $G_c$ ; et
- d'un ou plusieurs germes périphériques $G_{p2}$, contigu(s) aux germe(s) $G_c$ ;

les germes $G_{p2}$ présentent, dans un plan vertical de coupe, une largeur $l_{p2}$ strictement inférieure à la largeur le d'un germe central $G_a$; et étant dimensionnés de manière à ce que :

$$0 < l_{p2} < d_2\text{-}b,$$

avec :

- $d_2$, représentant la distance séparant la paroi du creuset de l'interface zone multicristalline/monocristalline en haut du lingot de hauteur H, vérifiant : $d_2$ = H.tan $\theta_{max}$, avec $\theta_{max}$ la valeur maximale de l'angle $\theta$ du front de solidification du four utilisé ; et H étant la hauteur, mesurée selon l'axe (Z), du lingot de silicium souhaitée ; et
- b=0 pour un creuset à angles droits, et b=$R_{interne\ creuset}$, avec $R_{interne\ creuset}$ la taille du chanfrein pour un creuset à arrêtes arrondies.

La valeur $\theta_{max}$ peut être plus particulièrement déterminée par un essai préalable de solidification dirigée, comme décrit précédemment.

Comme représenté schématiquement en figure 10, les joints de grains 6 se propageant au cours de l'étape de solidification dirigée du lingot, à partir des joints de germes entre joints périphériques $G_{p2}$ et joints centraux $G_c$ ne sont pas des joints de grains symétriques.

Néanmoins, ils permettent de stopper efficacement la propagation des macles 5 créées à partir de la zone multicristalline 4.

Un lingot monocristallin, d'excellente qualité cristalline, peut ainsi être obtenu par découpe du lingot obtenu à l'issue de l'étape (ii) de solidification dirigée, le long des plans $P_2$ parallèles aux parois latérales du creuset, à une distance $d_2$ de la paroi du creuset, comme représenté en figure 10.

Dans le cas d'un front de solidification proche de la planéité en fin de solidification du lingot, le joint de grains 6 se propageant à partir des joints de germes entre $G_p$ et $G_c$ acquiert une quasi-verticalité en haut du lingot. La découpe du lingot de coeur est aisément identifiable, dans la mesure où elles se situent au niveau des frontières entre germes $G_p$ et germes centraux $G_c$.

L'invention va maintenant être décrite au moyen de l'exemple suivant donné bien entendu à titre illustratif et non limitatif de l'invention.

**EXEMPLES**

**1. Détermination de la valeur maximale de l'angle θ du front de solidification du four**

Le four de cristallisation utilisé pour les essais de reprise sur germes est un four de taille « *Gen 2* » (60 à 80 kg de charge) possédant trois zones de chauffe pilotées en température ou en puissance : une zone de chauffe haute, une zone de chauffe basse et une zone de chauffe latérale.

Le creuset utilisé pour cet essai est un creuset en silice revêtu de $Si_3N_4$ de taille G2 (390 x 390 mm$^2$).

Un lingot multicristallin est réalisé dans le creuset, suivant une recette thermique spécifique développée pour obtenir un lingot multicristallin respectant les critères qualité de briques standards.

Ce type de creuset est entouré d'un contre-creuset en graphite servant à limiter la dilatation de la silice qui, lors de la montée en température au cours du cycle et la transition vitreuse associée, devient visqueux.

La charge est constituée d'une masse de silicium électronique (9N) ou métallurgique (6N) plus ou moins importante suivant la taille de lingot voulu, la quantité en dopant qu'il soit de type P (bore) ou de type N (phosphore) est calculée en fonction de la résistivité et du type désirée.

Après expérience, le lingot de silicium est découpé suivant un plan vertical de coupe, pour déterminer le front de solidification du four à l'aide d'une étude métallographique ou de résistivité.

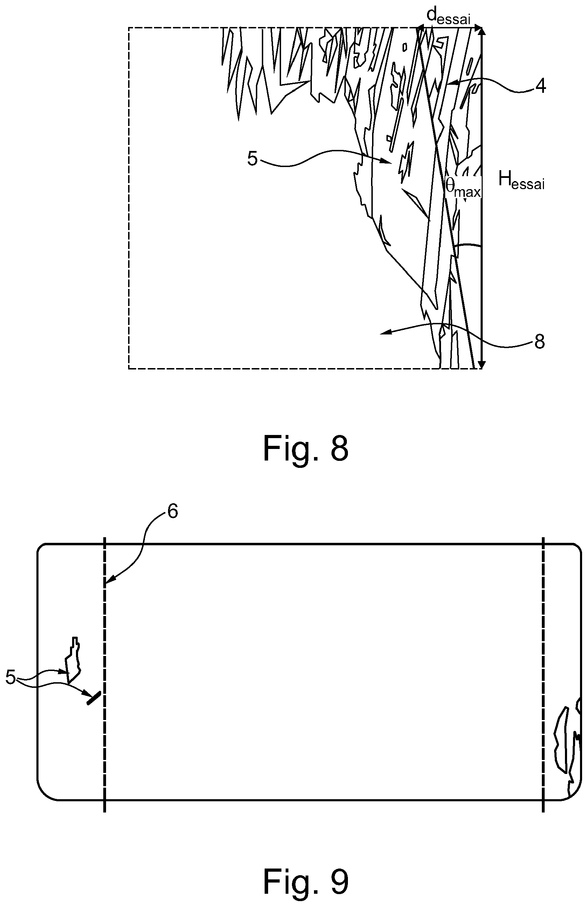

A l'aide d'une étude cristallographique (comme représenté schématiquement en figure 8), il est possible de déterminer facilement les différentes dimensions nécessaires :

$H_{essai}$ = 180 mm
$\theta_{max}$ = 10,7°

Et :

$$d_{essai} = H_{essai} \cdot \tan \theta_{max}$$

$d_{essai}$ = 34 mm

Au vu de l'angle $\theta_{max}$ (10,7°) du front de solidification du four utilisé, et de la taille du chanfrein présent pour ce creuset (b=14 mm), les germes périphériques doivent présenter une largeur minimale de 20 mm.

**2. Fabrication du lingot de silicium**

*2.i. Réalisation du pavage de germes $G_c$ et $G_p$*

On réalise un pavage du fond du creuset (creuset et contre-creuset identiques à ceux utilisés dans l'essai précédent), comme représenté schématiquement en figure 2b, avec :

- dans la zone centrale, quatre germes $G_c$ de type Cz de dimensions 144 x 144 mm et d'épaisseur 20 mm. Ces lingots sont découpés dans un lingot de diamètre 8 pouces (202 mm) perpendiculairement à la direction de croissance du cristal. La reprise sur germe aura donc une croissance identique à la direction de croissance du germe Cz : proche de <100> ; et
- dans la zone périphérique au voisinage des parois du creuset et adjacents aux germes $G_c$, quatre germes périphériques $G_p$ de dimensions 28 x 317 mm et d'épaisseur 20 mm. Ces germes ont été prélevés dans un même lingot Cz et possèdent des orientations, suivant les trois directions, semblables aux germes centraux.

Ces germes ont été nettoyés par ultrasons dans un bac d'acétone et un bac d'éthanol pendant une durée de 30 minutes et ensuite attaqués dans une solution de soude à 10 % massique.

Les caractéristiques des germes utilisés sont présentées dans le tableau 1 ci-après.

TABLEAU 1 : Caractérisation des germes $G_c$ et $G_p$

| N° | Dimensions (mm) Largeur x longueur x épaisseur | type | Résistivité (Ω.cm) |
|---|---|---|---|
| $G_c$ 1 | 144 x 144 x 20 | P | 1,3 |
| $G_c$ 2 | 144 x 144 x 20 | P | 1,4 |
| $G_c$ 3 | 144 x 144 x 20 | P | 1,5 |

(suite)

| N° | Dimensions (mm) Largeur x longueur x épaisseur | type | Résistivité ($\Omega$.cm) |
|---|---|---|---|
| $G_c$ 4 | 144 x 144 x 20 | P | 1,7 |
| $G_p$ 1 | 28 x 317 x 20 | P | 1,5 à 1,7 |
| $G_p$ 2 | 28 x 317 x 20 | P | 1,5 à 1,7 |
| $G_p$ 3 | 28 x 317 x 20 | P | 1,5 à 1,7 |
| $G_p$ 4 | 28 x 317 x 20 | P | 1,3 à 1,5 |

*2. ii. Solidification dirigée de silicium par reprise sur germes dans le four*

On effectue la solidification dirigée d'une charge de silicium, identique à celle utilisée pour la détermination de la valeur maximale de l'angle $\theta$ du front de solidification du four (point 1.).

Résultats

En sortie de four, l'observation de la face supérieure du lingot indique la présence d'une zone monocristalline, premier indice sur la croissance monocristalline de bas en haut du lingot.
L'observation de la structure cristalline post découpe (photographie (180 mm x 388 mm) présentée en figure 9) démontre que la croissance de la zone monocristalline issue des germes centraux est maintenue sur toute la hauteur du lingot. Il peut être observé que les macles 5, créées à partir de la zone multicristalline, sont bloquées sur les extérieurs du lingot à l'aide des joints de grains 6 créés par les interfaces entre germes périphériques et germes centraux.

**Revendications**

**1.** Procédé de fabrication d'un lingot de silicium par reprise sur germes en four de solidification dirigée, comprenant au moins les étapes consistant en :

(i) disposer d'un creuset (1) d'axe (Z) longitudinal, dont le fond comporte un pavage de germes (2) de silicium monocristallin de forme prisme droit, le pavage étant formé :

- d'un ou plusieurs germes centraux $G_c$ ; et
- d'un ou plusieurs germes périphériques $G_p$, contigu(s) au(x) germe(s) $G_c$ ; et

(ii) procéder à la solidification dirigée de silicium par reprise sur germes, selon une direction de croissance colinéaire à l'axe (Z) ;

**caractérisé en ce qu'**un germe $G_p$ présente un réseau cristallin symétrique du réseau cristallin du germe $G_c$ contigu, par rapport au plan P défini par la frontière (3) entre lesdits germes $G_p$ et $G_p$ ;
à l'étape (ii), on procède à la solidification dirigée avec un front de solidification spatialement ou temporellement concave ;
le ou lesdits germes $G_p$ présentent, dans un plan vertical de coupe, une largeur ($l_p$) strictement inférieure à la largeur totale ($l_u$) du ou desdits germes centraux ; et
les germes périphériques $G_p$ sont dimensionnés de manière à ce que :

$$l_p = d - b$$

avec :

- d vérifiant : $d \geq H.\tan\theta_{max}$, avec $\theta_{max}$ la valeur maximale de l'angle $\theta$ du front de solidification du four utilisé, et H la hauteur, mesurée selon l'axe (Z), du lingot de silicium souhaitée ; et
- b=0 pour un creuset à angles droits, et b=$R_{interne\ creuset}$, avec $R_{interne\ creuset}$ la taille du chanfrein pour un creuset à arrêtes arrondies.

2. Procédé selon la revendication 1, la valeur $\theta_{max}$ étant déterminée à l'issue d'un essai de solidification dirigée, dans le même creuset (1), d'un lingot de silicium de hauteur $H_{essai}$ similaire à la hauteur H du lingot souhaité, obtenu par reprise sur germes, en particulier sur des germes issus d'un lingot de silicium élaboré selon une technique de tirage Czochralski, ou des germes issus d'un lingot élaboré selon un procédé de zone de flottation.

3. Procédé selon la revendication 2, la valeur $\theta_{max}$ étant calculée, à l'issue de l'essai de solidification dirigée, par la formule suivante : $\tan \theta_{max} = d_{essai}/H_{essai}$, avec $d_{essai}$ étant la distance la plus éloignée du bord de creuset où se situe la zone multicristalline pour le lingot de hauteur $H_{essai}$ obtenu lors de l'essai.

4. Procédé selon l'une quelconque des revendications précédentes, dans lequel les germes $G_c$ et $G_p$ sont issus d'un lingot de silicium élaboré selon une technique de tirage Czochralski; ou du recyclage d'un lingot élaboré lors d'une précédente solidification dirigée selon le procédé tel que défini en revendication 1, par prélèvement d'une tranche horizontale du lingot formé.

5. Procédé selon l'une quelconque des revendications précédentes, dans lequel les germes $G_c$ et $G_p$ présentent une épaisseur (e) suivant l'axe (Z), supérieure ou égale à 5 mm.

6. Procédé selon l'une quelconque des revendications précédentes, dans lequel le ou lesdits germes $G_p$ présentent, dans un plan vertical de coupe, une largeur ($l_p$) inférieure ou égale à 157 mm, en particulier comprise entre 5 et 40 mm.

7. Procédé selon l'une quelconque des revendications précédentes, dans lequel le ou lesdits germes $G_c$ présentent, dans un plan vertical de coupe, une largeur ($l_c$) comprise entre 110 mm et $l_u/n$ avec n le nombre de germes centraux accolés, n étant en particulier compris entre 1 et 10.

8. Procédé selon l'une quelconque des revendications précédentes, dans lequel les germes $G_c$ présentent la forme d'un pavé droit de base carrée ou rectangulaire.

9. Procédé selon l'une quelconque des revendications 1 à 8, dans lequel le creuset est à arrêtes arrondies, le germe $G_p$ étant espacé de la paroi latérale (1) du creuset d'une distance (b) égale à la taille du chanfrein du creuset $R_{interne}$ creuset, en particulier allant de 2 à 40 mm.

10. Procédé selon l'une quelconque des revendications précédentes, le creuset étant dimensionné en fonction de la largeur ($l_p$) des germes périphériques préalablement déterminée et de la largeur ($l_u$) souhaitée.

11. Procédé selon l'une quelconque des revendications précédentes, dans lequel chaque germe $G_c$ présente un réseau cristallin symétrique du réseau cristallin du germe $G_c$ qui lui est contigu, par rapport au plan défini par la frontière entre les deux germes $G_c$ contigus.

12. Procédé selon l'une quelconque des revendications précédentes, la désorientation totale $2\varphi$ entre les réseaux cristallins symétriques d'un germe $G_p$ et d'un germe $G_c$ contigus étant supérieure ou égale à 4°, en particulier supérieure ou égale à 5°, et plus particulièrement comprise entre 6° et 45°.

13. Procédé de fabrication d'un lingot de silicium monocristallin selon l'une quelconque des revendications précédentes, comprenant au moins une étape (iii) de découpe du lingot obtenu en fin d'étape (ii), le long des plans P définis par l'interface entre deux germes $G_c$ et $G_p$ contigus, de manière à éliminer les zones multicristallines formées à l'aplomb des germes $G_p$.

14. Procédé selon la revendication précédente, dans lequel le lingot de silicium monocristallin isolé à l'issue de l'étape (iii) présente une part multicristalline inférieure à 5 % de son volume total.


**Patentansprüche**

1. Verfahren zur Herstellung eines Silizium-Ingots durch Gewinnung auf Keimen in einem Ofen zur gerichteten Erstarrung, das mindestens die folgenden Schritte umfasst:

   (i) Bereitstellen eines Schmelztiegels (1) mit einer Längsachse (Z), dessen Boden einen Belag von Keimen (2) aus monokristallinem Silizium mit der Form eines geraden Prismas trägt, wobei der Belag aus Folgendem gebildet wird:

- einem oder mehreren zentralen Keimen $G_c$ und
- einem oder mehreren peripheren Keimen $G_p$, die an den Keim bzw. die Keime $G_c$ angrenzen, und

(ii) Durchführen der gerichteten Erstarrung des Siliziums durch Gewinnung auf Keimen in einer mit der Achse (Z) kollinearen Wachstumsrichtung,

**dadurch gekennzeichnet, dass** ein Keim $G_p$ ein zu dem Kristallgitter des daran angrenzenden Keims $G_c$, bezogen auf die Ebene P, die durch die Grenze (3) zwischen den Keimen $G_p$ und $G_c$ definiert wird, symmetrisches Kristallgitter aufweist,
in Schritt (ii) die gerichtete Erstarrung mit einer räumlich oder zeitlich konkaven Erstarrungsfront durchgeführt wird,
der Keim oder die Keime $G_p$ in einer vertikalen Schnittebene eine Breite ($l_p$) aufweist/aufweisen, die strikt kleiner ist als die Gesamtbreite ($l_u$) des zentralen Keims oder der zentralen Keime, und
die peripheren Keime $G_p$ so bemessen sind, dass:

$$l_p = d - b$$

wobei:

- für d gilt: $d \geqq H.\tan \theta_{max}$, wobei $\theta_{max}$ der maximale Wert des Winkels $\theta$ der Erstarrungsfront des verwendeten Ofens ist und H die entlang der Achse (Z) gemessene gewünschte Höhe des Silizium-Ingots ist, und
- b=0 für einen Tiegel mit rechten Winkeln und b=Ri$_{nnen\ Tiegel}$, wobei $R_{innen\ Tiegel}$ die Größe der Abschrägung bei einem Tiegel mit abgerundeten Kanten ist.

2. Verfahren nach Anspruch 1, wobei der Wert $\theta_{max}$ nach einem Test der gerichteten Erstarrung, in demselben Tiegel (1), eines Silizium-Ingots mit einer Höhe H$_{Test}$, die mit der gewünschten Höhe H des Ingots vergleichbar ist, der durch Gewinnung auf Keimen, insbesondere auf Keimen, die von einem gemäß der Czochralski-Ziehtechnik hergestellten Silizium-Ingot stammen, oder Keimen, die von einem gemäß dem Zonenschmelzverfahren hergestellten Ingot stammen, erhalten wird, bestimmt wird.

3. Verfahren nach Anspruch 2, wobei der Wert $\theta_{max}$ nach dem Test der gerichteten Erstarrung durch die folgende Gleichung berechnet wird: $\tan \theta_{max} = d_{Test}/H_{Test}$, wobei $d_{Test}$ der am weitesten entfernte Abstand von der Kante des Tiegels ist, an dem sich die polykristalline Zone für den während des Tests erhaltenen Ingot der Höhe H$_{Test}$ befindet.

4. Verfahren nach einem der vorhergehenden Ansprüche, wobei die Keime $G_c$ und $G_p$ von einem gemäß der Czochralski-Ziehtechnik hergestellten Silizium-Ingot stammen oder aus dem Recycling eines bei einer vorherigen gerichteten Erstarrung gemäß dem Verfahren nach Anspruch 1 hergestellten Ingots stammen, indem eine horizontale Scheibe des gebildeten Ingots abgehoben wird.

5. Verfahren nach einem der vorhergehenden Ansprüche, wobei die Keime $G_c$ und $G_p$ eine Dicke (e) entlang der Achse (Z) von größer als oder gleich 5 mm besitzen.

6. Verfahren nach einem der vorhergehenden Ansprüche, wobei der Keim oder die Keime $G_p$ in einer vertikalen Schnittebene eine Breite ($l_p$) von weniger als oder gleich 157 mm, insbesondere zwischen 5 und 40 mm, besitzen.

7. Verfahren nach einem der vorhergehenden Ansprüche, wobei der Keim oder die Keime $G_c$ in einer vertikalen Schnittebene eine Breite ($l_c$) zwischen 110 mm und $l_u/n$ besitzen, wobei n die Anzahl der nebeneinander angeordneten zentralen Keime ist und n insbesondere zwischen 1 und 10 beträgt.

8. Verfahren nach einem der vorhergehenden Ansprüche, wobei die Keime $G_c$ die Form eines geraden Blocks mit quadratischer oder rechteckiger Grundfläche haben.

9. Verfahren nach einem der Ansprüche 1 bis 8, wobei der Schmelztiegel abgerundete Kanten aufweist, wobei der Keim $G_p$ von der Seitenwand (1) des Schmelztiegels um einen Abstand (b), der gleich der Größe der Abschrägung des Schmelztiegels $R_{innen\ Tiegel}$ ist und insbesondere von 2 bis 40 mm beträgt, beabstandet ist.

**10.** Verfahren nach einem der vorhergehenden Ansprüche, wobei der Schmelztiegel in Abhängigkeit von der zuvor bestimmten Breite ($l_p$) der peripheren Keime und der gewünschten Breite ($l_u$) bemessen ist.

**11.** Verfahren nach einem der vorhergehenden Ansprüche, wobei jeder Keim $G_c$ ein zu dem Kristallgitter des Keims $G_c$, der an ihn angrenzt, symmetrisches Kristallgitter, bezogen auf die durch die Grenze zwischen den zwei aneinandergrenzenden Keimen $G_c$ definierte Ebene, aufweist.

**12.** Verfahren nach einem der vorhergehenden Ansprüche, wobei die Gesamt-Desorientierung $2\varphi$ zwischen den symmetrischen Kristallgittern eines keims $G_p$ und eines daran angrenzenden Keims $G_c$ größer als oder gleich 4°, insbesondere größer als oder gleich 5° ist und ganz besonders zwischen 6° und 45° beträgt.

**13.** Verfahren zur Herstellung eines monokristallinen Silizium-Ingots nach einem der vorhergehenden Ansprüche, umfassend mindestens einen Schritt (iii) des Schneidens des nach Schritt (ii) erhaltenen Ingots entlang von Ebenen P, die durch die Grenzfläche zwischen zwei aneinandergrenzenden Keimen $G_c$ und $G_p$ definiert werden, um die lotrecht zu den Keimen $G_p$ gebildeten polykristallinen Zonen zu beseitigen.

**14.** Verfahren nach dem vorhergehenden Anspruch, wobei der nach Schritt (iii) isolierte monokristalline Silizium-Ingot einen polykristallinen Anteil von weniger als 5% seines Gesamtvolumens aufweist.

**Claims**

**1.** A process for manufacturing a silicon ingot by seeded regrowth in a directional solidification furnace, comprising at least the steps consisting of:

(i) providing a crucible (1) of longitudinal axis (Z), the bottom of which comprises a tiling of monocrystalline silicon seeds of straight prism shape, the tiling being formed:

- from one or more central seeds $G_c$; and
- from one or more peripheral seeds $G_p$, adjacent to the seed(s) $G_c$; and

(ii) carrying out the directional solidification of silicon by seeded regrowth, in a growth direction collinear to the axis (Z);

**characterized in that** a seed Gp has a crystal lattice symmetrical to the crystal lattice of the adjacent seed $G_c$, relative to the plane P defined by the boundary (3) between said seeds $G_p$ and Gc;
at step (ii), the directional solidification is carried out with a spatially or temporally concave solidification front;
said seed(s) $G_p$ having, in a vertical cutting plane, a width ($l_p$) strictly smaller than the total width ($l_u$) of said central seed(s); and
the peripheral seeds $G_p$ being sized so that:

$$l_p = d - b$$

with:

- d satisfying: $d \geq H.\tan \theta_{max}$, wherein $\theta_{max}$ is the maximum value of the angle $\theta$ of the solidification front of the furnace used, and H is the desired height, measured along the axis (Z), of the silicon ingot; and
- b=0 for a crucible with right angles, and b=$R_{internal}$ crucible, wherein $R_{internal \ crucible}$ is the size of the bevel for a crucible with rounded edges.

**2.** The process as claimed in claim 1, wherein the value $\theta_{max}$ is determined at the end of a directional solidification test, in the same crucible (1), of a silicon ingot having a height $H_{test}$ similar to the height H of the desired ingot, obtained by seeded regrowth, in particular with seeds being derived from a silicon ingot obtained by a Czochralski pulling technique, or seeds being derived from an ingot obtained by a float zone process.

**3.** The process as claimed in claim 2, wherein the value $\theta_{max}$ is calculated, at the end of the directional solidification test, by the following formula: $\tan \theta_{max}= d_{test}/H_{test}$, wherein $d_{test}$ is the distance furthest away from the edge of the crucible where the multicrystalline zone lies for the ingot of height $H_{test}$ obtained during the test.

4. The process as claimed in any one of the preceding claims, wherein the seeds $G_c$ and $G_p$ are derived from a silicon ingot obtained by a Czochralski pulling technique; or from the recycling of an ingot produced during a previous directional solidification according to the process as defined in claim 1, by removing a horizontal slice of the ingot formed.

5. The process as claimed in any one of the preceding claims, wherein the seeds $G_c$ and $G_p$ have a thickness (e) along the axis (Z) of greater than or equal to 5 mm.

6. The process as claimed in any one of the preceding claims, wherein said seed(s) $G_p$ have, in a vertical cutting plane, a width ($l_p$) of less than or equal to 157 mm, in particular of between 5 and 40 mm.

7. The process as claimed in any one of the preceding claims, wherein said seed(s) $G_c$ have, in a vertical cutting plane, a width ($l_c$) of between 110 mm and $l_u$/n wherein n is the number of central seeds placed side-by-side, n being in particular between 1 and 10.

8. The process as claimed in any one of the preceding claims, wherein the seeds $G_c$ have the shape of a square- or rectangular-based straight block.

9. The process as claimed in any one of claims 1 to 8, wherein the crucible has rounded edges, the seed Gp being spaced away from the side wall (1) of the crucible by a distance (b) equal to the size of the bevel of the crucible $R_{internal\ crucible}$, in particular ranging from 2 to 40 mm.

10. The process as claimed in any one of the preceding claims, wherein the crucible is sized as a function of the previously determined width ($l_p$) of the peripheral seeds and of the desired width ($l_u$).

11. The process as claimed in any one of the preceding claims, wherein each seed $G_c$ has a crystal lattice symmetrical to the crystal lattice of the seed $G_c$ which is adjacent thereto, relative to the plane defined by the boundary between the two adjacent seeds $G_c$.

12. The process as claimed in any one of the preceding claims, wherein the total disorientation $2\varphi$ between the symmetrical crystal lattices of a seed $G_p$ and of an adjacent seed $G_c$ is greater than or equal to 4°, in particular greater than or equal to 5°, and more particularly between 6° and 45°.

13. A process for manufacturing a monocrystalline silicon ingot according to any one of the preceding claims, comprising at least a step (iii) of cutting the ingot obtained at the end of step (ii), along planes P defined by the interface between two adjacent seeds $G_c$ and $G_p$, so as to eliminate the multicrystalline zones formed directly above the seeds $G_p$.

14. The process as claimed in the preceding claim, wherein the monocrystalline silicon ingot isolated at the end of step (iii) has a multicrystalline part of less than 5% of its total volume.

Fig. 1

Fig. 2a

Fig. 2b

Fig. 2

Fig. 3a

Fig. 3b

Fig. 3

Fig. 4a

Fig. 4b

Fig. 4

Fig. 5

Fig. 6

Fig. 7

Fig. 8

Fig. 9

Fig. 10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2007084934 A
- US 20100192838 A
- US 20100193989 A
- US 20100193664 A
- WO 2009014963 A
- US 20100197070 A
- US 20130095028 A
- WO 2009014957 A

**Littérature non-brevet citée dans la description**

- **FUJIWARA et al.** Growth of structure-controlled polycrystalline silicion ingots for solar cells by casting. *Acta Materialia,* 2006, vol. 54, 3191-3197
- **KUTSUKAKE K et al.** Control of grain boundary propagation in mono-like Si: utilization of functional grain boundaries. *Applied Physics Express,* 2013, vol. 6, 025505